# EUROPEAN PATENT APPLICATION

(11) **EP 1 821 346 A2**
(43) Date of publication of application: **22.08.2007**
(21) Application number: 07003425.1
(22) Date of filing: 19.02.2007
(51) Int. Cl.: H01L 33/00

(54) **Semiconductor light-emitting device and method of manufacturing the same**

(30) Priority: 20.02.2006 JP 2006042071
(71) Applicant: Sony Corporation, Minato-ku Tokyo 108-0075 (JP)
(72) Inventor: Kuromizu, Yuichi, Tokyo 108-0075 (JP)
(74) Representative: Müller - Hoffmann & Partner

(57) **Abstract**

A semiconductor light-emitting device includes: a semiconductor layer including a light-emitting region and having an emission surface on its surface; an insulating layer arranged on a surface of the semiconductor layer opposite to ; a first metal layer deposited on a surface of the insulating layer opposite to a surface where the semiconductor layer is arranged; a contact portion buried in a part of the insulating layer, the contact portion electrically connecting the semiconductor layer and the first metal layer; and a second metal layer having higher reflectivity with respect to a light-emitting wavelength than the first metal layer, the second metal layer arranged on a surface of the first metal layer opposite to a surface where the insulating layer is arranged, wherein a metal of which the first metal layer is made has higher adhesion to the insulating layer than a metal of which the second metal layer is made.

## Description

The present invention contains subject matter related to Japanese Patent Application JP 2006-042071 filed in the Japanese Patent Office on February 20, 2006, the entire contents of which being incorporated herein by reference.

### BACKGROUND OF THE INVENTION

### 1. Field of the Invention

The present invention relates to a semiconductor light-emitting device having an ODR (Omni-Directional-Reflector) structure and a method of manufacturing the same.

### 2. Description of the Related Art

In recent years, there is a demand for semiconductor light-emitting devices such as high-power light-emitting diodes as light sources for liquid crystal displays and projectors. One of them is a light-emitting diode having an ODR structure for extracting emitted light in one direction (refer to Japanese Unexamined Patent Application Publication No. S52-37783). In the ODR structure, an insulating layer made of SiO₂ (silicon dioxide) or the like is arranged between a semiconductor layer having a light-emitting region and a reflective metal layer made of Au (gold), Ag (silver) or the like, and an ohmic electrode is formed in a part of the insulating layer so that the semiconductor layer and the reflective metal layer can be electrically connected to each other. In such a structure, the reflectivity of the reflective metal layer can be improved, and light generated inside can be efficiently extracted to outside, so a high-power diode can be formed.

However, in the semiconductor light-emitting device having such an ODR structure, the reflective metal layer may be peeled during a process, energization or the like, so it is very difficult to handle the semiconductor light-emitting device having such an ODR structure. It is because the reflective metal layer with high reflectivity made of Au, Ag or the like has low adhesion to the insulating layer.

### SUMMARY OF THE INVENTION

To reduce the tendency to peel in the semiconductor light-emitting device with the ODR structure, it is necessary to increase the adhesion of the reflective metal layer to the insulating layer; however, it is difficult to increase only adhesion with the related art structure in which the reflective metal layer is directly laminated on the insulating layer. Therefore, for the purpose of bonding the insulating layer and the reflective metal layer together, it is necessary to provide a junction layer.

As a technique using a junction metal layer, there is disclosed a technique of bonding a compound semiconductor layer including a light-emitting layer portion, a reflective metal layer, and a supporting substrate together with a metal layer made of Au or the like in between in a step of manufacturing a semiconductor light-emitting device with a structure different from the ODR structure (refer to Japanese Unexamined Patent Application Publication No. 2005-56956). In general, the compound semiconductor layer is formed so as to have a very thin thickness, so when a substrate for growth is removed, subsequent handling is very difficult; however, in the manufacturing method, the device itself is reinforced by the bonded metal layer or supporting substrate, and the handling ability after removing the substrate for growth is improved.

However, the above-described semiconductor light-emitting device does not have the ODR structure, and the semiconductor light-emitting device has a laminating structure not including an insulating layer, so the purpose of providing the junction layer in the semiconductor light-emitting device is different from that in a device with the ODR structure in which it is necessary to increase the adhesion of the reflective metal layer to the insulating layer. Therefore, it is difficult to apply the above-described laminating structure using the junction metal layer to the semiconductor light-emitting device with the ODR structure.

In view of the foregoing, it is desirable to provide a semiconductor light-emitting device capable of improving adhesion of a metal layer having high reflectivity to an insulating layer without reducing the reflectivity of the metal layer, and a method of manufacturing the semiconductor light-emitting device.

According to an embodiment of the invention, there is provided a semiconductor light-emitting device including: a semiconductor layer including a light-emitting region and having an emission surface on its surface; an insulating layer arranged on a surface of the semiconductor layer opposite to the emission surface; a first metal layer deposited on a surface of the insulating layer opposite to a surface where the semiconductor layer is arranged; a contact portion buried in a part of the insulating layer, the contact portion electrically connecting the semiconductor layer and the first metal layer; and a second metal layer having higher reflectivity with respect to a light-emitting wavelength than the first metal layer, the second metal layer arranged on a surface of the first metal layer opposite to a surface where the insulating layer is arranged, wherein a metal of which the first metal layer is made has higher adhesion to the insulating layer than a metal of which the second metal layer is made.

In the semiconductor light-emitting device, light emitted from the light-emitting region in the semiconductor layer is emitted from a surface of the semiconductor layer, and light emitted to the back surface is reflected from the first metal layer, the alloy region and the second metal layer, and then emitted from the surface of the semiconductor layer. By the first metal layer between the second metal layer and the insulating layer, the adhesion strength between the second metal layer and the insulating layer is improved; however, the alloy region is included in an interface between the first metal layer and the second metal layer, so even in the case where the first metal layer is arranged between the insulating layer and the second metal layer, the function of the second metal layer as a reflective layer is not substantially hampered.

According to an embodiment of the invention, there is provided a method of manufacturing a semiconductor light-emitting device including the steps of: forming a semiconductor layer including a light-emitting region on a growth substrate, and then forming an insulating layer on the semiconductor layer; forming a contact hole in the insulating layer, and then forming a contact portion by filling the contact hole with a metal for ohmic contact; forming a first metal layer on the insulating layer; forming a second metal layer on the first metal layer, the second metal layer having higher reflectivity with respect to a light-emitting wavelength than the first metal layer; and forming an alloy region in an interface between the first metal layer and the second metal layer, wherein a metal of which the first metal layer is made has higher adhesion to the insulating layer than a metal of which the second metal layer is made.

The first metal layer is made of a metal having higher adhesion to the insulating layer than the metal of the second metal layer, and easily alloying the second metal layer, and more specifically, in the case where the second metal layer is made of Au (gold) or Ag (silver), the first metal layer is made of Al (aluminum), and an annealing process is performed at a temperature of 400°C or less, preferably 300°C to 400°C, thereby the alloy region can be formed.

In the method of manufacturing a semiconductor light-emitting device according to the embodiment of the invention, metals are mutually diffused near the interface between the first metal layer and the second metal layer by the annealing process, thereby the alloy region is formed between the first metal layer and the second metal layer. Therefore, while the reflection efficiency in a reflective layer (the second metal layer) is substantially maintained, the adhesion of the second metal layer to the insulating layer is improved.

In the semiconductor light-emitting device according to the embodiment of the invention, in an ODR structure, the first metal layer made of a metal having higher adhesion to the insulating layer than the metal of which the second metal layer is made and easily alloying with the second metal layer is arranged between the insulating layer and the second metal layer as the reflective layer, so the adhesion of the reflection layer (the second metal layer) to the insulating layer can be improved without substantially reducing the reflectivity by the reflective layer.

Moreover, in the method of manufacturing a semiconductor light-emitting device according to the embodiment of the invention, after the first metal layer and the second metal layer are formed on the insulating layer, the alloy region is formed in an interface between the first metal layer and the second metal layer by the annealing process, so the semiconductor light-emitting device according to the embodiment of the invention in which while the reflection efficiency in the reflective layer (the second metal layer) is substantially maintained, the adhesion of the second metal layer to the insulating layer is improved can be effectively manufactured.

Other and further objects, features and advantages of the invention will appear more fully from the following description.

### BRIEF DESCRIPTION OF THE DRAWINGS

FIG. 1 is a sectional view of a red light-emitting diode according to an embodiment of the invention;
FIG. 2 is a partially enlarged view of FIG. 1;
FIGs. 3A, 3B and 3C are illustrations for describing steps of manufacturing the light-emitting diode shown in FIG. 1;
FIGs. 4A and 4B are illustration for describing steps following FIGs. 3A, 3B and 3C;
FIG. 5 is a plot showing a relationship between light-emitting wavelengths and reflectivity in a device according to an example of the invention;
FIG. 6 is a plot showing a relationship between light-emitting wavelengths and reflectivity in a device according to an example of the invention;

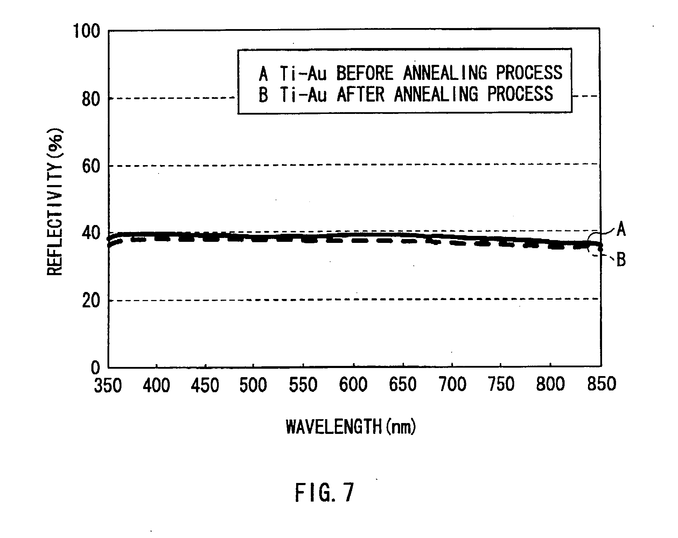

FIG. 7 is a plot showing a relationship between light-emitting wavelengths and reflectivity in a device according to a comparative example; and
FIG. 8 is an illustration for describing the range of the thickness of an insulating layer.

### DETAILED DESCRIPTION OF THE PREFERRED EMBODIMENTS

A preferred embodiment will be described in detail below referring to the accompanying drawings.

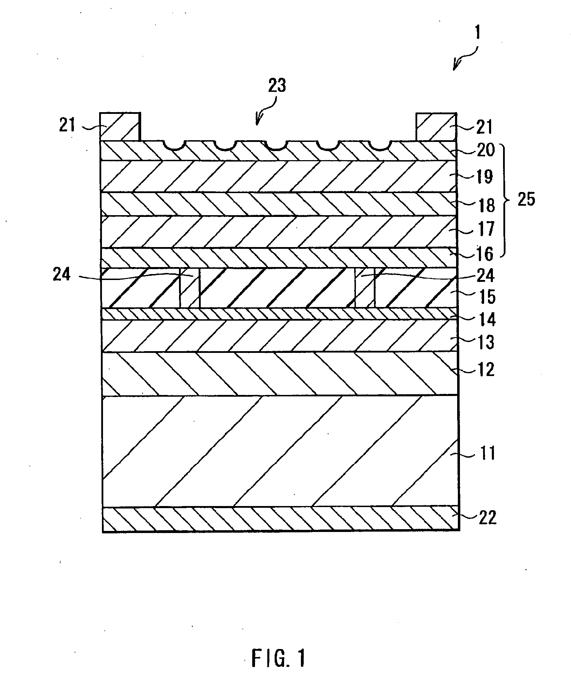

FIG. 1 shows a sectional view of a surface-emitting type red light-emitting diode 1 according to an embodiment of the invention. The light-emitting diode 1 includes a semiconductor layer 25 in which an ohmic contact layer 12, a second metal layer 13, a first metal layer 14, an insulating layer 15, a p-type contact layer 16, a p-type cladding layer 17, a MQW (Multiple Quantum Well) active layer 18, an n-type cladding layer 19 and an n-type contact layer 20 are laminated on a surface of a supporting substrate 11 in this order, and has an ODR structure. In other words, a contact portion 24 is buried in a region of the insulating layer 15 between the p-type contact layer 16 and the first metal layer 14, thereby the first metal layer 14 and the p-type contact layer 16 are electrically connected to (make ohmic contact with) each other. A p-side electrode 22 is arranged on the back surface of the supporting substrate 11, and an n-side electrode 21 is arranged on the n-type contact layer 20.

The supporting substrate 11 is made of, for example, a conductive substrate such as a plate-shaped GaAs (gallium arsenide) substrate or a plate-shaped GaP (gallium phosphide) substrate. The ohmic contact layer 12 on the supporting substrate 11 has, for example, a structure in which an AuGe (gold-germanium) layer, a Ni (nickel) layer and an Au layer are laminated in this order, and the thicknesses of the AuGe layer, the Ni layer, and the Au layer are, for example, 160 nm, 45 nm and 400 nm, respectively.

The second metal layer 13 is made of a metal having high reflectivity in a red light-emitting region, for example, Au, Ag or the like. For example, in the case where Au is used, the thickness of the second metal layer 13 is preferably 200 nm to 400 nm inclusive, and more preferably approximately 300 nm.

The first metal layer 14 is made of a metal having higher adhesion to the insulating layer 15 than a metal of which the second metal layer 13 is made, and easily alloying with the second metal layer 13 at a low temperature. As a metal satisfying these conditions, in the case where the second metal layer 13 is made of Au or Ag, for example, Al (aluminum) is cited. In the case where Al is used as the first metal layer 14, the thickness is preferably 5 nm to 30 nm inclusive, more preferably 10 nm to 20 nm inclusive, and more preferably approximately 10 nm.

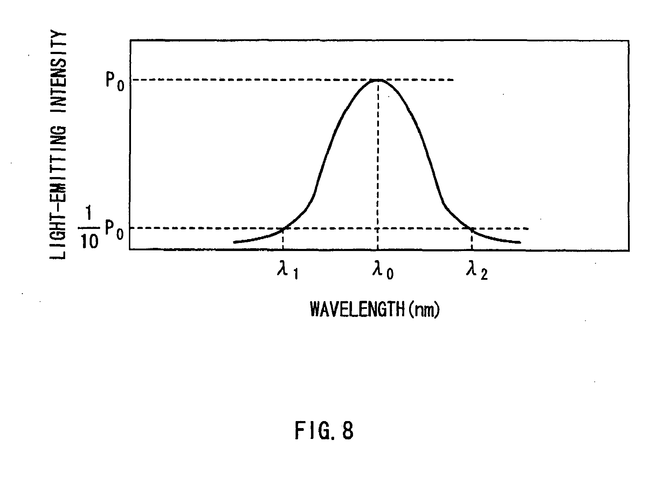

The insulating layer 15 is made of, for example, SiO₂, SiN (silicon nitride) or the like. The thickness of the insulating layer 15 is preferably m λ₁/(4n₁) to m λ₂/(4n₂) inclusive, more preferably m λ₀/(4n₀) (m is an integer). As shown in FIG. 8, λ₀ is a light-emitting peak wavelength, and λ₁ and λ₂ are wavelengths showing light-emitting intensity equal to 1/10 of light-emitting intensity Po in λ₀. Moreover, no, n₁ and n₂ are refractive indexes corresponding to the wavelengths λ₀, λ₁ and λ₂, respectively. Since the insulating layer 15 is formed so as to have such a thickness, light absorption in the insulating layer 15 is prevented, and light use efficiency is further improved. Moreover, the contact portion 24 is made of a metal, for example, AuZn (gold zinc) capable of making ohmic contact between the p-type contact layer 16 (made of an AlGaInP-based semiconductor) and the first metal layer 14 (made of Al). The number of the contact portions 24 is an arbitrary number; however, in terms of improving reflection efficiency, the total area of the contact portions 24 is approximately 10% or less of the total area of the insulating layer 15, and preferably approximately 4%.

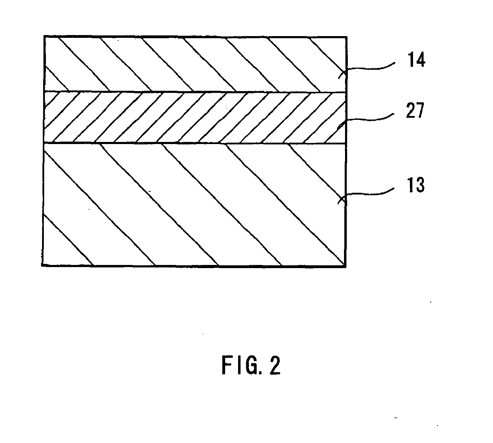

As shown in an enlarged view of FIG. 2, an alloy region 27 is formed in an interface between the second metal layer 13 and the first metal layer 14 by mutually diffusing a metal (in this case, Al) of which the second metal layer 13 is made and a metal (in this case, Au or Ag) of which the first metal layer 14 is made in an annealing step which will be described later.

The p-type contact layer 16, the p-type cladding layer 17, the MQW active layer 18, the n-type cladding layer 19 and the n-type contact layer 20 are made of an AlGaInP-based semiconductor. The AlGaInP-based semiconductor is a compound semiconductor including a Group 3B element Al, Ga (gallium) or In (indium) and a Group 5B element P (phosphorus) in the long form of the periodic table of the elements. The n-side electrode 21 and the p-side electrode 22 are formed so as to have, for example, a laminating structure including an AuGe layer, a Ni layer and an Au layer.

Next, an example of a method of manufacturing the light-emitting diode 1 having such a structure will be described below.

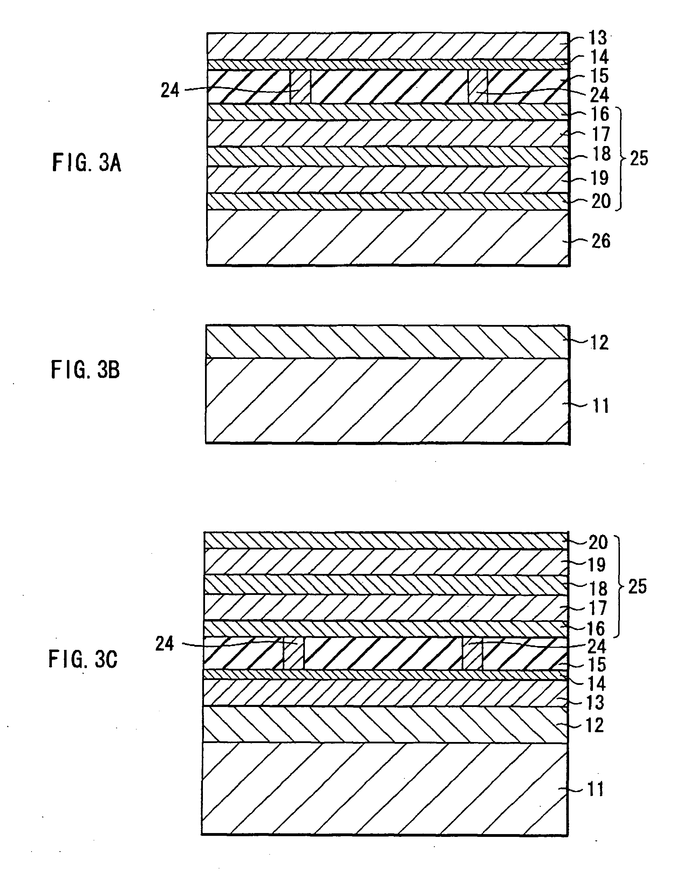

At first, as shown in FIG. 3A, the semiconductor layer 25 with an ODR structure is formed. In other words, an AlGaInP-based semiconductor layer is grown on a growth substrate 26 made of GaAs by, for example, a MOCVD (Metal Organic Chemical Vapor Deposition) method. At this time, examples of materials used for growth are trimethyl aluminum (TMA) for Al, trimethyl gallium (TMG) for Ga, trimethyl indium (TMIN) for In and phosphine (PH₃) for P, and as a material of an acceptor impurity, for example, dimethyl zinc (DMZn) is used. More specifically, the n-type contact layer 20, the n-type cladding layer 19, the MQW active layer 18, the p-type cladding layer 17 and the p-type contact layer 16 are grown on a surface of the growth substrate 26 in this order to form the semiconductor layer 25.

After that, the insulating layer 15 made of, for example, SiO₂ is formed on the grown p-type contact layer 16 by, for example, p-CVD (Plasma Enhanced Chemical Vapor Deposition) or sputtering. Then, after a contact hole with approximately Φ 10 µm is formed in a part of the insulating layer 15 by, for example, photolithography and wet etching with a hydrofluoric acid etchant, the contact portion 24 is formed, for example, by filling the hole with AuZn by, for example, evaporation or sputtering.

Next, after the first metal layer 14 with a thickness of, for example 10 nm and the second metal layer 13 with a thickness of, for example, 300 nm are deposited on the whole surface of the insulating layer 15 by, for example, evaporation or sputtering, an annealing process is performed at, for example, 400°C. By the annealing process, metals (Au and Al) contained in the second metal layer 13 and the first metal layer 14 are mutually diffused to form the alloy region 27. The temperature at that time is preferably 300°C to 400°C. When the temperature is lower than 300°C, it takes longer time to mutually diffuse Al and Au, and when it is higher than 400°C, ohmic contact between Al and Au becomes poor.

On the other hand, as shown in FIG. 3B, for example, an AuGe layer, a Ni layer and an Au layer are evaporated on the supporting substrate 11 in this order to form the ohmic contact layer 12.

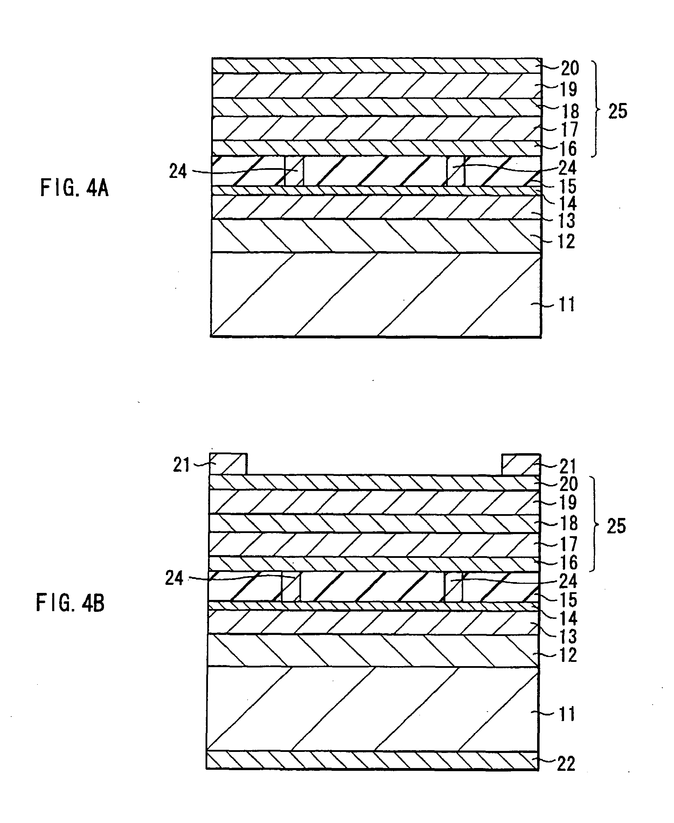

Next, as shown in FIG. 3C, the metal surface of the ohmic contact layer 12 and the surface of the second metal layer 13 are put together, and compression bonded while heating them at a temperature of, for example, approximately 400°C, and the supporting substrate 11 is bonded to the semiconductor layer 25 on the growth substrate 26. After that, as shown in FIG. 4A, the growth substrate 26 is removed from the semiconductor layer 25 by polishing and chemical etching. Finally, as shown in FIG. 4B, an AuGe layer, a Ni layer and an Au layer are formed on the n-type contact layer 20 in this order by, for example, evaporation to form the n-side electrode 21. At the same time, the p-side electrode 22 is formed on the supporting substrate 11. Finally, an annealing process is performed to complete the device.

In the light-emitting diode 1 according to the embodiment formed in such a manner, light emitted upward from the MQW active layer 18 is emitted via an aperture (light-emitting opening) 23 of the n-side electrode 21; however, a part of light emitted downward passes through the insulating layer 15, and is reflected from the first metal layer 14 and the second metal layer 13, and then the part of light is emitted from the aperture 23.

Thus, in the embodiment, the semiconductor layer 25 including a light-emitting region (the MQW active layer 18), the insulating layer 15, the first metal layer 14 made of a metal having high adhesion to the insulating layer 15 and easily alloying with the second metal layer 13 at a low temperature, and the second metal layer 13 are laminated in this order, and the second metal layer 13 and the first metal layer 14 are mutually diffused by a low-temperature annealing process at 400°C or less, thereby the alloy region 27 is formed between the second metal layer 13 and the first metal layer 14. Moreover, the light-emitting diode 1 has a structure in which the second metal layer 13 with such an ODR structure and the supporting substrate 11 are bonded together with the ohmic contact layer 12 in between.

In the embodiment, the first metal layer 14 is disposed between the second metal layer 13 and the insulating layer 15, so the adhesion strength of the second metal layer 13 to the insulating layer 15 is increased. Moreover, the element itself is reinforced by the bonded supporting substrate 11, so handling ability is improved. As the alloy region 27 is formed by mutually diffusing metals contained in the second metal layer 13 and the first metal layer 14, the first metal layer 14 is provided between the insulating layer 15 and the second metal layer 13, thereby the reflection efficiency of light emitted from the MQW active layer 18 of the semiconductor layer 25 does not greatly decline, and the function of the second metal layer 13 as a reflective layer is not substantially hampered.

### <Examples>

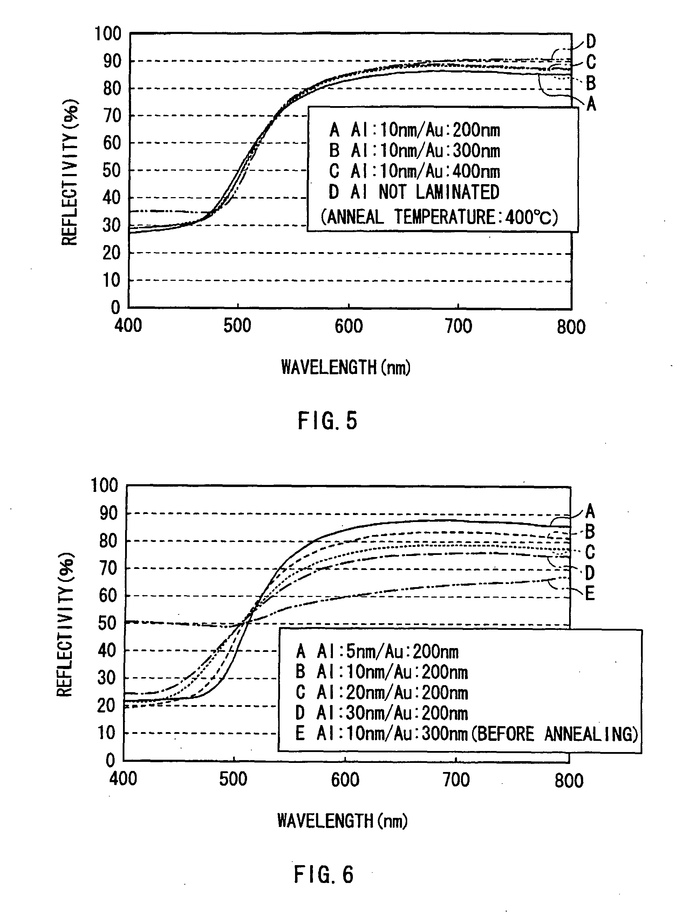

Here, changes in reflectivity by providing the first metal layer 14 between the insulating layer 15 and the reflective layer (the second metal layer 13) were studied, compared to the case of using only the reflective layer. More specifically, as the insulating layer, a glass substrate was used, and a metal layer made of Al and a metal layer made of Au were deposited on the glass substrate in order, and light entered from the glass substrate side to measure reflectivity. FIGs. 5 and 6 show a relationship between light-emitting wavelengths and reflectivity at that time.

At first, a plot of FIG. 5 shows measurement results in the case where an Al layer was not laminated (indicated by D in the plot) and the cases where the thickness of the Al layer was 10 nm, and the thickness of the Au layer was 200 nm (indicated by A in the plot), 300 nm (indicated by B in the plot) and 400 nm (indicated by C in the plot). An annealing process after laminating Al was performed at 400°C. In this case, the reflectivity in a region of a wavelength of 630 nm was 88% in the case where Al was not laminated (that is, the case where only the Au layer was included), and when the Al layer with a thickness of 10 nm was laminated, the reflectivity was 84.99% in the case where the thickness of the Au layer was 200 nm, 86.91% in the case where the thickness of the Au layer was 300 nm, and 87.43% in the case where the thickness of the Au layer was 400 nm. It was obvious from the results that even if an Al thin film was provided between the insulating layer (the glass substrate) and an Au thin film to form an alloy region, the reflectivity hardly declined around the region. Moreover, the larger the thickness of the Au layer is, the more the reflectivity is increased; however, even if the thickness of the Au layer is set to be 400 nm or over, a large increase in the reflectivity is not expected, so in consideration of costs of materials, the appropriate thickness is 200 nm to 400 nm inclusive, and preferably approximately 300 nm.

Next, a plot of FIG. 6 shows measurement results in the case where the thickness of the Au layer was 200 nm, and the thickness of the laminated Al layer was 5 nm (indicated by A in the plot), 10 nm (indicated by B in the plot), 20 nm (indicated by C in the plot) and 30 nm (indicated by D in the plot). The annealing process was performed at 400°C as in the above-described case. In this case, the reflectivity in a region of a wavelength of 630 nm was 86.72% in the case of the thickness of the Al layer was 5 nm, 82.37% in the case where the thickness was 10 nm, 77.59% in the case where the thickness was 20 nm, and 74.56% in the case where the thickness was 30 nm. It was obvious from the results that the thinner the thickness of the Al layer was, the less the reflectivity declined. However, when the thickness of the Al layer was 5 nm, a part of the device was peeled, so sufficient adhesion to an insulator could not be obtained. Therefore, it is necessary for the Al layer to have at least a thickness of 5 nm or over, and preferably approximately 10 nm.

Moreover, FIG. 6 also shows a relationship between light-emitting wavelengths and reflectivity in the case where the annealing process was not performed after laminating the Al layer (indicated by E in the plot). When a measurement was carried out with the Al layer with a thickness of 10 nm and the Au layer with a thickness of 300 nm, the reflectivity in a region of a wavelength of 650 nm was 61.93%. Therefore, it was found out that when the annealing process was not performed after laminating the Al layer, Au and Al were not mutually diffused, thereby the alloy region was not formed, so the Al layer interfered with reflection to cause a large decline in the reflectivity.

It was obvious from the above results that in the case of a laminating structure in which a metal layer made of Au and a metal layer made of Al were deposited on an insulating layer made of a glass substrate in order, when the thicknesses of Al and Au were set to be 10 nm and 300 nm, respectively, and the annealing process was performed at approximately 400°C, adhesion of the Au layer to the glass substrate was improved, and a decline in the reflectivity was reduced.

### <Comparative Examples>

As a metal having high adhesion to an insulator such as SiO₂, Ti (titanium) is typically used. In the case where a metal thin film made of Ti and a metal thin film made of Au were deposited on an insulating glass substrate in order, and light entered from the glass substrate side, the reflectivity was measured. A relationship between light-emitting wavelengths and reflectivity is shown in FIG. 6. The reflectivity before and after the annealing process at 450°C after Ti with a thickness of 10 nm and Au with a thickness of 300 nm were deposited was measured. As a result, the adhesion to an insulator was improved, so the device was not peeled. However, the reflectivity in a region of a wavelength of 630 nm was 38.70% before the annealing process, and 37.21% after the annealing process, so the reflectivity was hardly changed before and after the process, and remained low. It is considered that as Ti has a high melting point, Ti and Au are not mutually diffused by the annealing process at a low temperature, thereby they are not alloyed. Therefore, it is not preferable to select Ti as the metal of the first metal layer 14.

Although the invention is described referring to the embodiment, the invention is not specifically limited to the embodiment, and can be variously modified. For example, in the embodiment, the light-emitting diode is described; however, the invention is applicable to a semiconductor light-emitting device as a laser. Moreover, in the embodiment, the invention is described through the use of an AlGaInP-based compound semiconductor light-emitting device as an example; however, the invention is applicable to any other compound semiconductor light-emitting device, for example, a light-emitting device using an AlInP-based or a GaInAs-based material.

Further, in the embodiment, a structure in which the supporting substrate 11 is bonded to the second metal layer 13 of the ODR structure including the semiconductor layer 25, the insulating layer 15, the second metal layer 13 and the first metal layer 14 is used; however, in the invention, such a structure is not necessarily used. For example, a structure in which the second metal layer 13 functions as a p-side electrode, or a structure in which a p-side electrode is directly formed on the second metal layer 13 may be used. In addition, in the embodiment, a structure in which the ring-shaped n-side electrode 21 is formed on a surface of the n-type contact layer 20 is used; however, the n-side electrode 21 may have any other shape as long as light emitted from inside can be extracted.

It should be understood by those skilled in the art that various modifications, combinations, sub-combinations and alterations may occur depending on design requirements and other factors insofar as they are within the scope of the appended claims or the equivalents thereof.

## Claims

1. A semiconductor light-emitting device comprising:
a semiconductor layer including a light-emitting region and having an emission surface on its surface;
an insulating layer arranged on a surface of the semiconductor layer opposite to the emission surface;
a first metal layer deposited on a surface of the insulating layer opposite to a surface where the semiconductor layer is arranged;
a contact portion buried in a part of the insulating layer, the contact portion electrically connecting the semiconductor layer and the first metal layer; and
a second metal layer having higher reflectivity with respect to a light-emitting wavelength than the first metal layer, the second metal layer arranged on a surface of the first metal layer opposite to a surface where the insulating layer is arranged,
wherein a metal of which the first metal layer is made has higher adhesion to the insulating layer than a metal of which the second metal layer is made.

2. The semiconductor light-emitting device according to claim 1,
wherein
the second metal layer includes an alloy region in an interface with the first metal layer.

3. The semiconductor light-emitting device according to claim 1,
wherein
the thickness of the insulating layer is m λ₁/(4n₁) to m λ₂/(4n₂) inclusive (where m is an integer, λ₁ and λ₂ are wavelengths showing light-emitting intensity equal to 1/10 of light-emitting intensity P₀ in a light-emitting peak wavelength λ₀ in the light-emitting region (λ₁ < λ₂), and n₁ and n₂ are refractive indexes corresponding to the wavelengths λ₁ and λ₂, respectively).

4. The semiconductor light-emitting device according to claim 1,
wherein
the metal of which the second metal layer is made is Au (gold) or Ag (silver).

5. The semiconductor light-emitting device according to claim 1,
wherein
the metal of which the first metal layer is made is Al (aluminum).

6. The semiconductor light-emitting device according to claim 1,
wherein
the second metal layer has a thickness of 200 nm or over.

7. The semiconductor light-emitting device according to claim 1,
wherein
the first metal layer has a thickness of 30 nm or less.

8. The semiconductor light-emitting device according to claim 1,
wherein
a conductive supporting substrate is bonded to the second metal layer, and an electrode is arranged on a surface of each of the supporting substrate and the semiconductor layer.

9. A method of manufacturing a semiconductor light-emitting device comprising the steps of:
forming a semiconductor layer including a light-emitting region on a growth substrate, and then forming an insulating layer on the semiconductor layer;
forming a contact hole in the insulating layer, and then forming a contact portion by filling the contact hole with a metal for ohmic contact;
forming a first metal layer on the insulating layer;
forming a second metal layer on the first metal layer, the second metal layer having higher reflectivity with respect to a light-emitting wavelength than the first metal layer; and
forming an alloy region in an interface between the first metal layer and the second metal layer,
wherein a metal of which the first metal layer is made has higher adhesion to the insulating layer than a metal of which the second metal layer is made.

10. The method of manufacturing a semiconductor light-emitting device according to claim 9, wherein
the thickness of the insulating layer is m λ₁/(4n₁) to m λ₂/(4n₂) inclusive (where m is an integer, λ₁ and λ₂ are wavelengths showing light-emitting intensity equal to 1/10 of light-emitting intensity Po in a light-emitting peak wavelength λ₀ in the light-emitting region (λ₁< λ₂), and n₁ and n₂ are refractive indexes corresponding to the wavelengths λ₁ and λ₂, respectively).

11. The method of manufacturing a semiconductor light-emitting device according to claim 9, wherein
the first metal layer is made of a metal easily alloying with the second metal layer.

12. The method of manufacturing a semiconductor light-emitting device according to claim 9, wherein
the second metal layer is made of Au (gold) or Ag (silver), and the first metal layer is made of Al (aluminum), and an annealing process is performed at a temperature of 400°C or less to form the alloy region.

13. The method of manufacturing a semiconductor light-emitting device according to claim 9, comprising the steps of:
forming an ohmic contact layer on a conductive supporting substrate;
bonding the ohmic contact layer and the second metal layer;
removing the growth substrate; and
forming electrodes on the back surface of the supporting substrate and the semiconductor layer.
